(19) Europäisches Patentamt
European Patent Office
Office européen des brevets

(11) **EP 4 709 123 A1**

(12) **EUROPEAN PATENT APPLICATION**

(43) Date of publication:
**11.03.2026 Bulletin 2026/11**

(21) Application number: **25193958.3**

(22) Date of filing: **05.08.2025**

(51) International Patent Classification (IPC):
**H10K 59/80** (2023.01)    **G02F 1/1335** (2006.01)

(52) Cooperative Patent Classification (CPC):
**G02F 1/133509; H10K 59/879; H10K 59/8791**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **05.09.2024 CN 202411240584**

(71) Applicant: **InnoLux Corporation
Jhunan Town
Miao Ii 35053 (TW)**

(72) Inventors:
• **LIU, Fang-Yi**
**35053 Jhunan Town, Miaoli County (TW)**
• **KUO, Chiung-Chieh**
**35053 Jhunan Town, Miaoli County (TW)**
• **HUANG, Chi-Ming**
**35053 Jhunan Town, Miaoli County (TW)**
• **CHU, Wei-Ming**
**35053 Jhunan Town, Miaoli County (TW)**

(74) Representative: **Becker, Eberhard
Becker Kurig & Partner
Patentanwälte mbB
Bavariastraße 7
80336 München (DE)**

(54) **DISPLAY DEVICE**

(57)    A display device includes a display panel (100) and an anti-reflective film (200). The anti-reflective film (200) is disposed on the display panel (100). The anti-reflective film (200) includes a first high refractive index layer (210) and a first low refractive index layer (220) stacked in sequence. A thickness (T1) of the first high refractive index layer (210) is greater than a thickness (T2) of the first low refractive index layer (220). Under irradiation of a CIE standard illuminant D65 light source, a reflected light of the display device (10) satisfies the following conditions in the CIE L*a*b* color space: $0 \geq a^* \geq -6$ and $0 \geq b^* \geq -6$. The display device (10) of the disclosure may reduce reflectivity of ambient light or improve visual effects.

FIG. 1

**Description**

**BACKGROUND**

Technical Field

The disclosure relates to a display device, and in particular to a display device that may reduce reflectivity of ambient light or improve visual effects.

Description of Related Art

The electronic device or the tiled electronic device is widely applied in different fields such as communication, display, automotive, or aviation. With the rapid development of the electronic device, the electronic device is developing to become lighter and thinner, so the reliability or quality requirement for the electronic device is becoming higher.

**SUMMARY**

The disclosure provides a display device that may reduce reflectivity of ambient light or improve visual effects.
According to an embodiment of the disclosure, a display device includes a display panel and an anti-reflective film. The anti-reflective film is disposed on the display panel. The anti-reflective film includes a first high refractive index layer and a first low refractive index layer stacked in sequence. A thickness of the first high refractive index layer is greater than a thickness of the first low refractive index layer. Under irradiation of a CIE standard illuminant D65 light source, a reflected light of the display device satisfies the following conditions in the CIE L*a*b* color space: $0 \geq a^* \geq -6$ and $0 \geq b^* \geq -6$.

**BRIEF DESCRIPTION OF THE DRAWINGS**

The accompanying drawings are included to provide a further understanding of the disclosure, and are incorporated in and constitute a part of this specification. The drawings illustrate exemplary embodiments of the disclosure and, together with the description, serve to explain the principles of the disclosure.

FIG. 1 is a cross-sectional schematic view of a display device in the first embodiment of the disclosure.
FIG. 2 is a cross-sectional schematic view of a display device in the second embodiment of the disclosure.
FIG. 3 is a cross-sectional schematic view of a display device in the third embodiment of the disclosure.
FIG. 4 shows a result of measuring reflectivity of a display device after adjusting a thickness of a refractive index layer.
FIG. 5 shows a result of measuring a hue of a reflected light of the display device of FIG. 4.

**DESCRIPTION OF THE EMBODIMENTS**

The disclosure may be understood with reference to the following detailed description taken in conjunction with the drawings. It should be noted that for the ease of understanding by the reader and the conciseness of the drawings, multiple drawings of the disclosure only depict a portion of an electronic device, and specific elements in the drawings may not be drawn according to actual scale. Furthermore, the number and the size of each element in the drawings are illustrative only and are not intended to limit the scope of the disclosure.
In the following specification and claims, terms such as "containing" and "including" are open-ended terms and should thus be interpreted to mean "comprising but not limited to...".
It should be understood that when an element or a film layer is referred to as being "on" or "connected to" another element or film layer, the element or film layer may be directly on the other element or film layer or directly connected to the other element or film layer, or there may be an element or a film layer inserted between the two (case of indirect connection). In contrast, when an element or a film layer is referred to as being "directly on" or "directly connected to" another element or film layer, there is no element or film layer inserted between the two.
Although terms such as "first", "second", and "third" may be used to describe multiple constituent elements, the constituent elements are not limited by the terms. The terms are only used to distinguish a single constituent element from other constituent elements in the specification. The claims may not use the same terms, which may be replaced by first, second, third... in the order of declaration of the elements in the claims. Therefore, in the following specification, a first constituent element may be a second constituent element in the claims.
In the text, the terms "about", "approximately", "substantially", and "roughly" usually mean within 10%, 5%, 3%, 2%, 1%, or 0.5% of a given value or range. The number given here is an approximate number, that is, in the case where "about", "approximately", "substantially", and "roughly" are not particularly described, the meanings of "about", "approximately", "substantially", and "roughly" may still be implied.

In some embodiments of the disclosure, terms related to bonding and connection such as "connection" and "interconnection", unless otherwise specified, may mean that two structures are in direct contact or may also mean that the two structures are not in direct contact, wherein there is another structure disposed between the two structures. Also, the terms related to bonding and connection may also include the case where the two structures are both movable or the two structures are both fixed. In addition, the term "coupling" includes any direct and indirect electrical connection means.

In some embodiments of the disclosure, an optical microscope (OM), a scanning electron microscope (SEM), a thin film thickness profilometer ($\alpha$-step), an ellipsometer, or other suitable manners may be used to measure an area, a width, a thickness, or a height of each element or a distance or a spacing between elements. In detail, according to some embodiments, the scanning electron microscope may be used to obtain a cross-sectional structural image including the element to be measured and measure the area, the width, the thickness, or the height of each element or the distance or the spacing between the elements.

In the disclosure, the electronic device may include a display device, light emitting device, backlight device, virtual reality device, augmented reality (AR) device, antenna device, sensing device, tiled device, or any combination thereof, but not limited thereto. The display device may be a non-self-luminous display or a self-luminous display according to requirements, and may be a color display or a monochrome display according to requirements. The antenna device may be a liquid crystal type antenna device or a non-liquid crystal type antenna device. The sensing device may be a device for sensing capacitance, light, thermal energy, or ultrasound. The tiled device may be a display tiled device or an antenna tiled device, but not limited thereto. The electronic units in the electronic device may include passive components and active components, such as capacitors, resistors, inductors, diodes, transistors, etc. The diode may include a light emitting diode (LED) or a photodiode. The light emitting diode may include, for example, an organic light emitting diode (OLED), a mini LED, a micro LED, or a quantum dot LED, but not limited thereto. The transistor may include, for example, a top gate thin film transistor, a bottom gate thin film transistor, or a dual gate thin film transistor, but not limited thereto. The electronic device may also include fluorescence materials, phosphor materials, quantum dot (QD) materials, or other suitable materials according to requirements, but not limited thereto. The electronic device may have peripheral systems such as driving systems, control systems, light source systems, etc. to support display devices, antenna devices, wearable devices (including augmented reality or virtual reality devices, for example), vehicle-mounted devices (including car windshields, for example), or tiled devices. It should be noted that the electronic device may be any permutation and combination of the above, but not limited thereto. The following will use a display device as an example to explain the content of the disclosure, but this disclosure is not limited thereto.

It should be noted that in the following embodiments, without departing from the spirit of the disclosure, features in several different embodiments may be replaced, reorganized, and mixed to complete other embodiments. As long as the features of the embodiments do not violate the spirit of the invention or are not conflicting, the features may be arbitrarily mixed and matched for use.

Reference will now be made in detail to the exemplary embodiments of the disclosure, and examples of the exemplary embodiments are illustrated in the drawings. Wherever possible, the same reference numerals are used in the drawings and the description to refer to the same or similar parts.

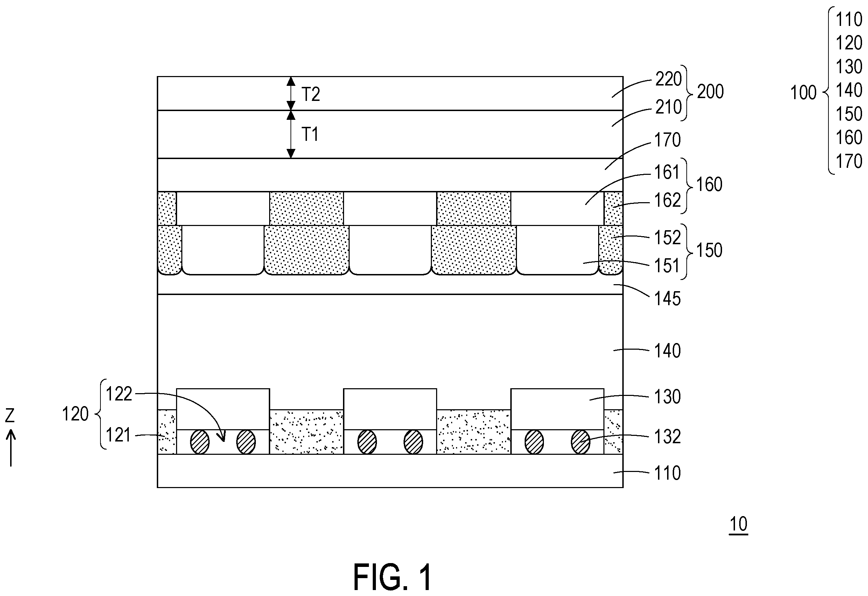

FIG. 1 is a cross-sectional schematic view of a display device in the first embodiment of the disclosure. Referring to FIG. 1, a display device 10 of the embodiment includes a display panel 100 and an anti-reflective film 200.

Specifically, the display panel 100 includes a first substrate 110, a pixel definition layer 120, a light emitting unit 130, an adhesive layer 140, an encapsulation layer 145, a color conversion unit 150, a color filter unit 160 and a second substrate 170. The first substrate 110 may be, for example, a circuit board including a circuit layer. For example, the first substrate 110 may be an active driving substrate used to drive the light emitting unit 130, and the active driving substrate may include driving circuits (not shown) such as transistors, scan lines, and data lines, but not limited thereto. In the embodiment, the first substrate 110 may include a rigid substrate, a flexible substrate or a combination of the foregoing. For example, the material of the first substrate 110 may include glass, quartz, sapphire, ceramic, polycarbonate (PC), polyimide (PI), polyethylene terephthalate (PET), other suitable substrate materials or a combination of the foregoing, but not limited thereto.

The pixel definition layer 120 is disposed on the first substrate 110. The pixel definition layer 120 includes a spacer 121 and an opening 122. The opening 122 may expose a portion of the first substrate 110.

The light emitting unit 130 is disposed between the first substrate 110 and the second substrate 170. The light emitting unit 130 is disposed on the first substrate 110 in the opening 122 of the pixel definition layer 120. The light emitting unit 130 may be electrically connected to the first substrate 110 through the pads 132. In the embodiment, the light emitting unit 130 may include an organic light emitting diode, an inorganic light emitting diode or a combination of the foregoing, but not limited thereto. The inorganic light emitting diode may be, for example, a mini light emitting diode or a micro light emitting diode.

The adhesive layer 140 is disposed between the light emitting unit 130 and the color conversion unit 150. The adhesive layer 140 may be used to bond the first substrate 110 and the second substrate 170. In the embodiment, the material of the adhesive layer 140 may include thermosetting glue, UV glue or a combination of the foregoing. For example, the material of the adhesive layer 140 may include optical clear adhesive (OCA), optical clear resin (OCR), other suitable bonding materials or a combination of the foregoing, but not limited thereto.

The encapsulation layer 145 is disposed between the adhesive layer 140 and the color conversion unit 150. In the embodiment, the material of the encapsulation layer 145 may include silicon oxide, silicon nitride, silicon oxynitride or a combination of the foregoing.

The color conversion unit 150 is disposed between the light emitting unit 130 and the color filter unit 160. The color conversion unit 150 includes a color conversion layer 151 and a barrier layer 152. In a direction Z (for example, a normal direction of the first substrate 110 or a normal direction of the display device 10), the color conversion layer 151 may overlap with and correspond to the light emitting unit 130, and the blocking layer 152 may overlap with and correspond to the spacer 121 of the pixel definition layer 120. In the embodiment, the color conversion layer 151 may include quantum dot, fluorescence, phosphor, or other suitable color conversion materials, or a combination of the foregoing, but not limited thereto.

The color filter unit 160 is disposed between the first substrate 110 and the second substrate 170. The color filter unit 160 is disposed between the light emitting unit 130 and the second substrate 170, and the color filter unit 160 is disposed between the color conversion unit 150 and the second substrate 170. The color filter unit 160 includes a color filter layer 161 and a black matrix 162. In the direction Z, the color filter layer 161 may overlap with and correspond to the light emitting unit 130, and the black matrix 162 may overlap with and correspond to the spacer 121 of the pixel definition layer 120. In the embodiment, the color filter layer 161 may include a red filter layer, a green filter layer, a blue filter layer or other suitable color filter layers, but not limited thereto.

The second substrate 170 is disposed on the color filter unit 160. The second substrate 170 is disposed between the color filter unit 160 and the anti-reflective film 200. The material of the second substrate 170 may refer to the material of the first substrate 110, including, for example, glass or other suitable transparent substrate materials, but not limited thereto.

The anti-reflective film 200 is disposed on the display panel 100. The anti-reflective film 200 may be a stacked structure of multiple layers. In the embodiment, the anti-reflective film 200 may include a first high refractive index layer 210 and a first low refractive index layer 220 stacked in sequence. The first high refractive index layer 210 is disposed between the second substrate 170 and the first low refractive index layer 220. In the embodiment, a refractive index of the first high refractive index layer 210 is between 2.0 and 2.5, and a refractive index of the first low refractive index layer 220 is between 1.0 and 1.5, but not limited thereto. In the embodiment, the material of the first high refractive index layer 210 may include niobium oxide ($Nb_2O_5$), titanium oxide ($TiO_2$) or tantalum oxide ($Ta_2O_5$), and the material of the first low refractive index layer 220 may include silicon oxide ($SiO_2$), magnesium fluoride ($MgF_2$) or calcium fluoride ($CaF_2$), but not limited thereto.

In the embodiment, since the anti-reflect film 200 may be a stacked structure of the first high refractive index layer 210 and the first low refractive index layer 220 stacked in sequence, when ambient light passes through refractive index layers with different refractive indices in the anti-reflect film 200, its reflected light may **produce** destructive interference due to the change in phase angle, thereby reducing reflectivity of the ambient light or improving the ambient contrast ratio to improve visual effects.

The first high refractive index layer 210 has a thickness T1, and the first low refractive index layer 220 has a thickness T2. The thickness T1 may be the maximum thickness of the first high refractive index layer 210 measured along the direction Z, and the thickness T2 may be the maximum thickness of the first low refractive index layer 220 measured along the direction Z. In the embodiment, the thickness T1 of the first high refractive index layer 210 and the thickness T2 of the first low refractive index layer 220 may be between 5 nanometers (nm) to 120 nm, but not limited thereto. In the embodiment, the thickness T1 of the first high refractive index layer 210 may be greater than the thickness T2 of the first low refractive index layer 220 to have a better anti-reflection effect, but not limited thereto.

For example, when the wavelength of ambient light is 550 nm, the refractive index of the first high refractive index layer 210 is 2.466, and the refractive index of the first low refractive index layer 220 is 1.479, the thickness T1 of the high refractive index layer 210 may be approximately 111.5 nm (that is, T1 = $550 / (2 \times 2.466)$), and the thickness T2 of the first low refractive index layer 220 may be approximately 93 nm (that is, T2 = $550 / (4 \times 1.479)$).

In the embodiment, under irradiation of a standard illuminator D65 light source of the International Commission on Illumination (CIE), a reflected light of the display device 10 may satisfy the following conditions in the CIE L*a*b* color space: $0 \geq a^* \geq -6$ and $0 \geq b^* \geq -6$. Among them, the L* value may represent the brightness of the reflected light, the a* value greater than 0 may indicate that the hue of the reflected light towards red, the a* value less than 0 may indicate that the hue of the reflected light towards green, the b* value greater than 0 may indicate that the hue of the reflected light towards yellow, and the b* value less than 0 may indicate that the hue of the reflected light towards blue.

Other embodiments will be listed below as illustrations. It must be noted here that the following embodiments continue to use the reference numerals and some content of the foregoing embodiments, wherein the same numerals are adopted to represent the same or similar elements, and the description of the same technical content is omitted. For the description of the omitted part, reference may be made to the foregoing embodiments and will not be repeated in the following embodiments.

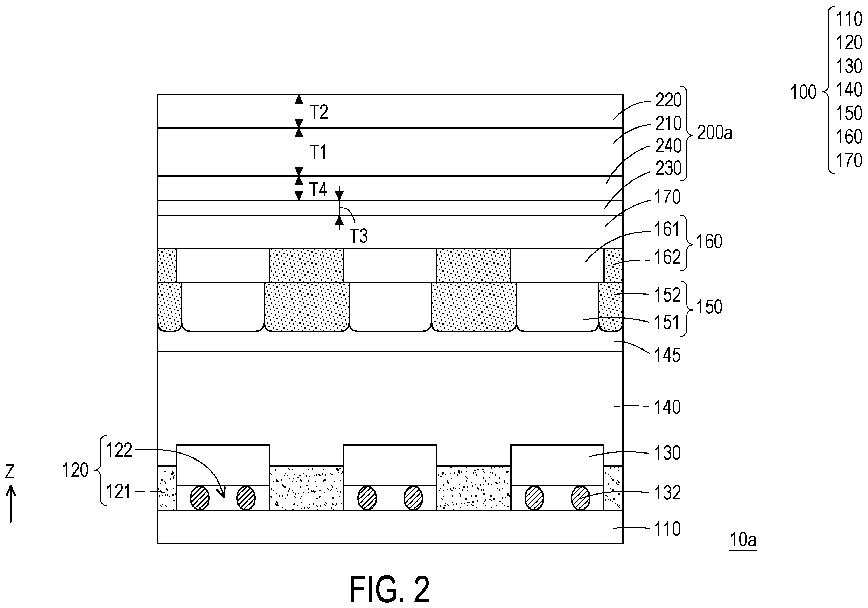

FIG. 2 is a cross-sectional schematic view of a display device in the second embodiment of the disclosure. Please refer to FIG. 2 and FIG. 1 at the same time. A display device 10a of the embodiment is similar to the display device 10 in FIG. 1. The only difference between the two is that in the display device 10a of the embodiment, the anti-reflective film 200a further includes a second high refractive index layer 230 and a second low refractive index layer 240 stacked in sequence.

Specifically, please refer to FIG. 2, a stack of the second high refractive index layer 230 and the second low refractive index layer 240 is disposed between the display panel 100 and the first high refractive index layer 210. The second high refractive index layer 230 is disposed between the second substrate 170 and the second low refractive index layer 240, and the second low refractive index layer 240 is disposed between the second high refractive index layer 230 and the first high refractive index layer 210.

In the embodiment, a refractive index of the second high refractive index layer 230 is between 2.0 and 2.5, and a refractive index of the second low refractive index layer 240 is between 1.0 and 1.5, but not limited thereto. In the embodiment, the material of the second high refractive index layer 230 may include niobium oxide, titanium oxide or tantalum oxide, and the material of the second low refractive index layer 240 may include silicon oxide, magnesium fluoride or calcium fluoride, but not limited thereto.

In the embodiment, since the anti-reflective film 200a may include two stacks of high refractive index layers and low refractive index layers (that is, a stack of the first high refractive index layer 210 and the first low refractive index layer 220, and a stack of the second high refractive index layer 230 and the second low refractive index layer 240), it may increase the quantity of destructive interference, thereby further reducing reflectivity of the ambient light or further improving the ambient light contrast to further improve visual effects.

The second high refractive index layer 230 has a thickness T3, and the second low refractive index layer 240 has a thickness T4. The thickness T3 may be the maximum thickness of the second high refractive index layer 230 measured along the direction Z, and the thickness T4 may be the maximum thickness of the second low refractive index layer 240 measured along the direction Z. In the embodiment, the thickness T3 of the second high refractive index layer 230 and the thickness T4 of the second low refractive index layer 240 may be between 5 nm and 120 nm, but not limited thereto. In the embodiment, the thickness T3 of the second high refractive index layer 230 may be smaller than the thickness T2 of the first low refractive index layer 220, and the thickness T4 of the second low refractive index layer 240 may be smaller than the thickness T2 of the first low refractive index layer 220, and the thickness T4 of the second low refractive index layer 240 may be greater than the thickness T3 of the second high refractive index layer 230 to have a better anti-reflection effect, but not limited thereto.

For example, when the wavelength of ambient light is 550 nm, the refractive index of the first high refractive index layer 210 and the second high refractive index layer 230 is 2.466, and the refractive index of the first low refractive index layer 220 and the second low refractive index layer 220 is 2.466, the thickness T1 of the first high refractive index layer 210 may be approximately 111.5 nm (that is, T1 = $550 / (2 \times 2.466)$), and the thickness T2 of the first low refractive index layer 220 may be approximately 93 nm (that is, T2 = $550 / (4 \times 1.479)$), and the thickness T3 of the second high refractive index layer 230 may be approximately 13.9 nm (that is, T3 = $550 / (16 \times 2.466)$), and the thickness T4 of the second low refractive index layer 240 may be approximately 23.2 nm (that is, T4 = $550 / (16 \times 1.479)$).

Although FIG. 2 schematically illustrates that the anti-reflective film 200a may include two stacks of high refractive index layers and low refractive index layers (that is, one is a stack of the first high refractive index layer 210 and the first low refractive index layer 220, and the other is a stack of the second high refractive index layer 230 and the second low refractive index layer 240), the disclosure does not limit the number of stacks of high refractive index layers and low refractive index layers that the anti-reflective film may include. In some embodiments, the anti-reflective film may include 2 to 12 stacks of high/low refractive index layers, but not limited thereto.

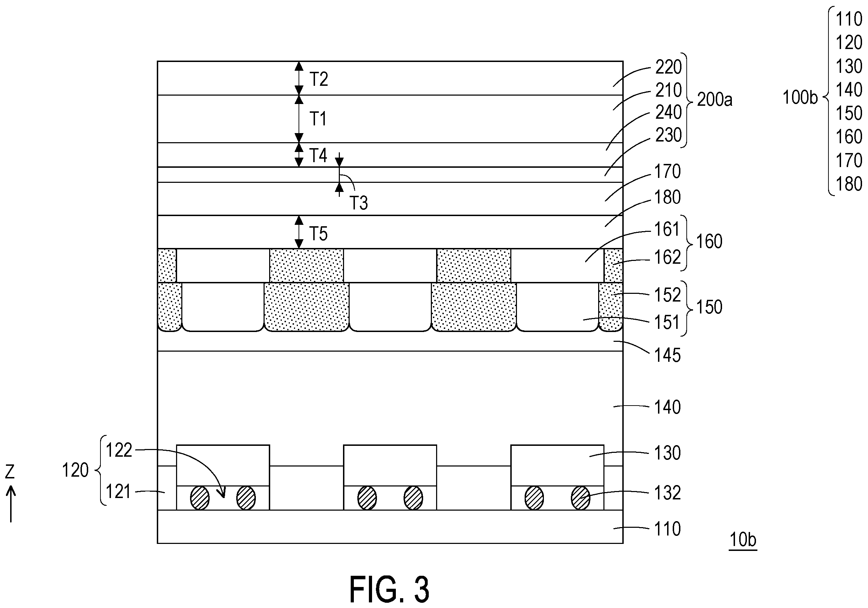

FIG. 3 is a cross-sectional schematic view of a display device in the third embodiment of the disclosure. Please refer to FIG. 3 and FIG. 2 at the same time. A display device 10b of the embodiment is similar to the display device 10a in FIG. 2. The only difference between the two is that in the display device 10b of the embodiment, the display panel 100b further includes an index matching film (IMF) 180.

Specifically, please refer to FIG. 3, the index matching film 180 is disposed between the color filter unit 160 and the second substrate 170. In the embodiment, a refractive index of the index matching film 180 is between 1.6 and 1.8, and the material of the index matching film 180 may be silicon oxynitride (SiONx) which is a mixture of silicon nitride and silicon oxide, but not limited thereto.

The index matching film 180 has a thickness T5, and the thickness T5 may be the maximum thickness of the index matching film 180 measured along the direction Z. In the embodiment, the thickness T5 of the index matching film 180 may be between 300 Å and 500 Å, but not limited thereto.

In the embodiment, the index matching film 180 may be used to interfere with ambient light passing through the second substrate 170, thereby reducing reflectivity of the ambient light or improving the ambient contrast ratio to improve visual effects.

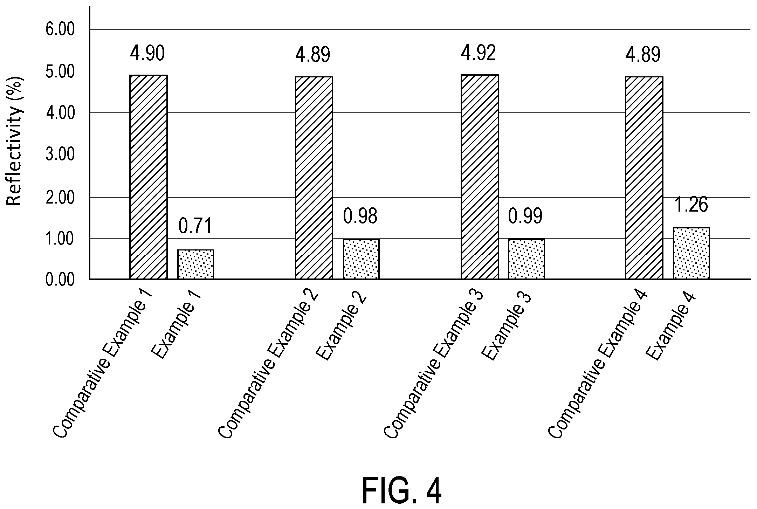

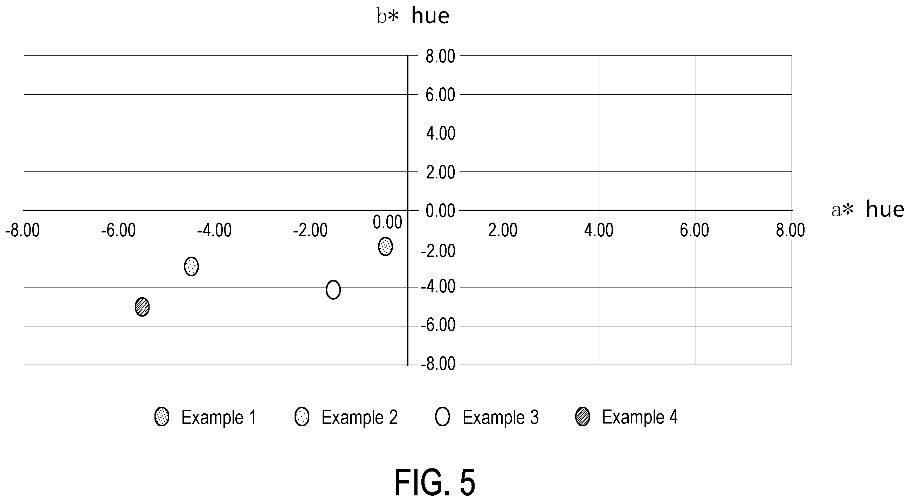

FIG. 4 shows a result of measuring reflectivity of a display device after adjusting a thickness of a refractive index layer. FIG. 5 shows a result of measuring a hue of a reflected light of the display device of FIG. 4.

Specifically, in the embodiment, using the display device 10b as shown in FIG. 3 and adjusting the thicknesses of the first high refractive index layer 210, the first low refractive index layer 220, the second high refractive index layer 230 and the second low refractive index layer 240 in the display device 10b according to Table 1 below to obtain display devices of Example 1, Example 2, Example 3 and Example 4 respectively. The material of the first high refractive index layer 210 is niobium oxide, the material of the first low refractive index layer 220 is silicon oxide, the material of the second high refractive index layer 230 is niobium oxide, and the material of the second low refractive index layer 240 is silicon oxide.

Table 1

|  | Example 1 | Example 2 | Example 3 | Example 4 |
|---|---|---|---|---|
| first low refractive index layer | 82.62 nm | 80.25 nm | 80.98 nm | 93.13 nm |
| first high refractive index layer | 107.35 nm | 106.93 nm | 106.85 nm | 105.25 nm |
| second low refractive index layer | 33.88 nm | 27.96 nm | 25.43 nm | 39.94 nm |
| second high refractive index layer | 10.15 nm | 9.19 nm | 10.69 nm | 11.16 nm |

In the embodiment, using the display device 10b as shown in FIG. 3 and removing the anti-reflective film to obtain the display devices of Comparative Example 1, Comparative Example 2, Comparative Example 3 and Comparative Example 4 respectively. That is, the main difference between the Examples (that is, Example 1, Example 2, Example 3 and Example 4) and the Comparative Examples (that is, Comparative Example 1, Comparative Example 2, Comparative Example 3 and Comparative Example 4) is whether there is an anti-reflective film.

Next, under the irradiation of the standard illuminant D65 light source of the International Commission on Illumination (CIE), the reflectivity of the Comparative Examples (that is, Comparative Example 1, Comparative Example 2, Comparative Example 3 and Comparative Example 4) and the Examples (that is, Example 1, Example 2, Example 3 and Example 4) is measured, and the hue of the reflected light of the Examples is measured in the CIE L*a*b* color space. The results are shown in FIG. 4 and FIG. 5 respectively .

According to the results of FIG. 4, the reflectivity of Comparative Example 1, Comparative Example 2, Comparative Example 3 and Comparative Example 4 are 4.90%, 4.89%, 4.92% and 4.89% respectively, and the reflectivity of Example 1 and Example 2, Example 3 and Example 4 are 0.71%, 0.98%, 0.99% and 1.26% respectively. Among them, the reflectivity of the Examples are significantly smaller than the reflectivity of the Comparative examples. That is, compared with the Comparative examples including the index matching film, the Examples including both the anti-reflection film and the index matching film may significantly reduce the reflectivity of ambient light. In addition, according to the difference in reflectivity between Example 1, Example 2, Example 3 and Example 4, the thickness changes

(such as changes in thickness values) of the high refractive index layer and the low refractive index layer in the anti-reflective film may affect the level of reflectivity.

According to the results of Figure 5, since the thicknesses of the first high refractive index layer, the first low refractive index layer, the second high refractive index layer and the second low refractive index layer in different Examples are all different, resulting in the a* value (or the b* value) of the reflected light in the CIE L*a*b* color space of different Examples is also different. That is, changes in the thickness of the high refractive index layer and the low refractive index layer in the anti-reflective film may also affect the hue of the reflected light. In addition, since the a* values in Example 1, Example 2, Example 3 and Example 4 are all less than 0 and greater than -6, and the b* values are also all less than 0 and greater than -6, it means that the hue of the reflected light in Example 1, Example 2, Example 3 and Example 4 in the CIE L*a*b* color space towards green and blue, which complies with OEM5.0 specifications.

In summary, in the display device of the embodiments of the disclosure, by disposing the anti-reflection film containing the first high refractive index layer and the first low refractive index layer on the display panel, the reflectivity of the ambient light may be reduced or the ambient light contrast may be improved, thereby enhancing the visual effects. Furthermore, by adjusting the thickness of the high refractive index layer and the low refractive index layer in the anti-reflection film, the reflected light of the display device in the CIE L*a*b* color space may satisfy the following conditions: $0 \geq a^* \geq -6$ and $0 \geq b^* \geq -6$. Additionally, by increasing the number of stacks of the high refractive index layer and the low refractive index layer in the anti-reflection film, the reflectivity of the ambient light may be further reduced.

**Claims**

1.    A display device (10), comprising:

a display panel (100); and

an anti-reflective film (200), disposed on the display panel (100) and comprises a first high refractive index layer (210) and a first low refractive index layer (220) stacked in sequence, wherein a thickness (T1) of the first high refractive index layer (210) is greater than a thickness (T2) of the first low refractive index layer (220);

wherein under irradiation of a CIE standard illuminator D65 light source, a reflected light of the display device (10) satisfies the following conditions in the CIE L*a*b* color space:

$$0 \geq a^* \geq -6 \text{ and } 0 \geq b^* \geq -6.$$

2. The display device according to claim 1, wherein a refractive index of the first high refractive index layer (210) is between 2.0 and 2.5.

3. The display device according to claim 1, wherein a refractive index of the first low refractive index layer (220) is between 1.0 and 1.5.

4. The display device according to claim 1, wherein the anti-reflective film (200) further comprises:
a second high refractive index layer (230) and a second low refractive index layer (240) stacked in sequence, disposed between the display panel (100) and the first high refractive index layer (210).

5. The display device according to claim 4, wherein the second low refractive index layer (240) is disposed between the second high refractive index layer (230) and the first high refractive index layer (210).

6. The display device according to claim 4, wherein a refractive index of the second high refractive index layer (230) is between 2.0 and 2.5, and a refractive index of the second low refractive index layer (240) is between 1.0 to 1.5.

7. The display device according to claim 4, wherein a thickness (T3) of the second high refractive index layer (230) is smaller than the thickness (T2) of the first low refractive index layer (220).

8. The display device according to claim 4, wherein a thickness (T4) of the second low refractive index layer (240) is smaller than the thickness (T2) of the first low refractive index layer (220).

9. The display device according to claim 4, wherein a thickness (T4) of the second low refractive index layer (240) is greater than a thickness (T3) of the second high refractive index layer (230).

10. The display device according to claim 1, wherein the display panel (100) comprises:

a first substrate (110);
a second substrate (170);
a light emitting unit (130), disposed between the first substrate (110) and the second substrate (170); and
a color filter unit (160), disposed between the first substrate (110) and the second substrate (170).

11. The display device according to claim 10, wherein the display panel (100) comprises:
a color conversion unit (150), disposed between the light emitting unit (130) and the color filter unit (160).

12. The display device according to claim 10, wherein the first high refractive index layer (210) is disposed between the second substrate (170) and the first low refractive index layer (220).

13. The display device according to claim 10, wherein the display panel (100) comprises:
an index matching layer (180), disposed between the color filter unit (160) and the second substrate (170).

14. The display device according to claim 13, wherein a refractive index of the index matching layer (180) is between 1.6 and 1.8.

15. The display device according to claim 13, wherein a thickness (T5) of the index matching layer (180) is between 300Å and 500Å.

FIG. 1

EP 4 709 123 A1

FIG. 2

FIG. 3

EP 4 709 123 A1

FIG. 4

FIG. 5

b* hue

a* hue

Example 1   Example 2   Example 3   Example 4

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2024/019605 A1 (KOBAYASHI TOMOAKI [JP]) 18 January 2024 (2024-01-18) | 1-9 | INV. H10K59/80 |
| Y | * figures 1-3 * * paragraph [0041] - paragraph [0150] * ----- | 10-15 | G02F1/1335 |
| Y | JP 2016 164855 A (SHARP KK) 8 September 2016 (2016-09-08) * figure Fig.1 * * paragraph [0028] - paragraph [0031] * ----- | 10-12 | |
| Y | KR 2019 0022346 A (JSR CORP [JP]) 6 March 2019 (2019-03-06) * figures 10-11 * * paragraph [0073] - paragraph [0084] * ----- | 10-12 | |
| Y | US 2023/384484 A1 (KUO YU-TONG [TW] ET AL) 30 November 2023 (2023-11-30) * figures 5-6 * * paragraph [0040] - paragraph [0046] * ----- | 13-15 | |

| | |
|---|---|
| | TECHNICAL FIELDS SEARCHED (IPC) |
| | H10K G02F |

The present search report has been drawn up for all claims

| Place of search | Date of completion of the search | Examiner |
|---|---|---|
| Munich | 28 November 2025 | Kentischer, Florian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 3958

This annex lists the patent family members relating to the patent documents cited in the above-mentioned European search report.
The members are as contained in the European Patent Office EDP file on
The European Patent Office is in no way liable for these particulars which are merely given for the purpose of information.

28-11-2025

| Patent document cited in search report | Publication date | Patent family member(s) | | Publication date |
|---|---|---|---|---|
| US 2024019605 A1 | 18-01-2024 | CN | 116368405 A | 30-06-2023 |
| | | EP | 4254022 A1 | 04-10-2023 |
| | | JP | 7042895 B1 | 28-03-2022 |
| | | JP | 7669264 B2 | 28-04-2025 |
| | | JP | 2022085293 A | 08-06-2022 |
| | | JP | 2022085904 A | 08-06-2022 |
| | | KR | 20230043212 A | 30-03-2023 |
| | | TW | 202229929 A | 01-08-2022 |
| | | US | 2024019605 A1 | 18-01-2024 |
| | | WO | 2022114037 A1 | 02-06-2022 |
| JP 2016164855 A | 08-09-2016 | NONE | | |
| KR 20190022346 A | 06-03-2019 | CN | 109426030 A | 05-03-2019 |
| | | JP | 2019040179 A | 14-03-2019 |
| | | KR | 20190022346 A | 06-03-2019 |
| | | TW | 201913200 A | 01-04-2019 |
| US 2023384484 A1 | 30-11-2023 | CN | 117198148 A | 08-12-2023 |
| | | TW | 202349035 A | 16-12-2023 |
| | | US | 2023384484 A1 | 30-11-2023 |

EPO FORM P0459

For more details about this annex : see Official Journal of the European Patent Office, No. 12/82